## Europäisches Patentamt
## European Patent Office
## Office européen des brevets

(11) Numéro de publication:

**0 265 330**
**A1**

(12) # DEMANDE DE BREVET EUROPEEN

(21) Numéro de dépôt: 87402314.6

(22) Date de dépôt: 16.10.87

(51) Int. Cl.⁴: **B 65 G 47/14**
B 65 G 15/58, H 01 L 21/00

(30) Priorité: 17.10.86 FR 8614422

(43) Date de publication de la demande:
27.04.88 Bulletin 88/17

(84) Etats contractants désignés:
CH DE GB IT LI NL

(71) Demandeur: THOMSON HYBRIDES ET MICROONDES
173, bld Haussmann
F-75008 Paris (FR)

(72) Inventeur: Noel, Georges
THOMSON-CSF SCPI 19, avenue de Messine
F-75008 Paris (FR)

Le Corre, Yves
THOMSON-CSF SCPI 19, avenue de Messine
F-75008 Paris (FR)

(74) Mandataire: Taboureau, James et al
THOMSON-CSF SCPI 19, avenue de Messine
F-75008 Paris (FR)

(54) **Appareil de manipulation de puces semiconductrices de petites dimensions.**

(57) L'invention concerne un dispositif de manipulation des puces semiconductrices de petites dimensions, telles que les puces hyperfréquences qui sont livrées en vrac.

En vue de prélever ces puces (3, 4, 5, 6), une à une, en un point précis au moyen d'une pipette (20), l'appareil met en oeuvre les charges d'électricité statique qui font adhérer les puces sur un ruban (1) sans fin, en matière plastique. Dans une première partie, verticale, le ruban (1) se charge de puces en traversant une trémie (2) d'alimentation : une butée (7) retient toutes les puces (6) sur une face du ruban, et une autre butée (9) ne laisse passer que les puces (3, 5) à plat sur l'autre face du ruban. Dans une deuxième partie horizontale, le ruban traverse une tunnel (11) dans lequel les puces (3) sont orientées, puis stockées, et prélevées (17) par une pipette aspirante (20).

Application au montage en boitier ou sur substrat des puces semiconductrices.

FIG_4

## Description

APPAREIL DE MANIPULATION DE PUCES SEMICONDUCTRICES DE PETITES DIMENSIONS.

La présente invention concerne un appareil de manipulation des puces de dispositifs semiconducteurs, tels que les diodes ou les transistors, de façon à présenter ces puces en un lieu précis, où elles sont prélevées par une pipette pour être fixées sur une embase, par une chaine de conditionnement automatique.

L'industrie des semiconducteurs nécessite toujours, à un moment donné, la manipulation de puces nues pour les fixer sur un support qui comporte les connexions d'accès à la fonction electrique, et souvent un capot de protection : ce support peut être l'embase d'un boitier de diode ou de transistor (type TO39), la grille d'un boitier de circuit intégré (type DIL) ou le substrat d'un circuit hybride.

Il existe des moyens et des procédés qui conviennent très bien tant que les purces à manipuler ont des dimensions qui, approximati-vement, sont supérieures à 1 mm de côté. Par exemple, il est connu qu'une tranche de matériau semiconducteur, dans laquelle des dispositifs ont été réalisés, est posée sur une feuille de matière plastique. Après découpe au laser ou au diamant de la tranche, la feuille de matière plastique est distendue : les puces sont à ce moment présentées en ordre et espacées, ce qui permet de les prendre avec une pipette aspirante.

Il n'en est plus de même s'il s'agit de puces très petites, de 0,25 à 0,4 - 0,5 mm de côté, correspondant à des diodes ou des transistors hyperfréquences - dont on sait que les dimensions sont d'autant plus petites que la fréquence est élevée. Les diodes peuvent également être opto-électroniques, de type électro-luminescentes ou lasers. Pour découper la tranche de matériau semiconducteur en puces aussi petites et de si faible poids, il est nécessaire de coller la tranche sur une embase, par exemple une plaque de cuivre. Les puces sont ensuite décollées puis nettoyées de la colle : elles sont à ce moment en vrac.

L'appareil et le procédé qui permettent de manipuler ces puces en vrac, pour les présenter à une pipette aspirante, reposent sur l'adhérence développée par l'électricité statique d'un ruban en matière plastique tel qu'un polyester. L'appareil comporte une trémie, sorte d'entonnoir vertical dans lequel sont déversées les puces. Un ruban de matière plastique, présentant un effet statique, traverse verticalement la trémie et entraine avec lui, vers le haut, des puces qui y adhèrent par électricité statique. Une première butée réglable, qui frotte d'un côté du ruban, fait retomber dans la trémie toutes les puces qui adhèrent sur cette face du ruban. Une seconde butée réglable, de l'autre côté du ruban, arrête toutes les puces qui adhèrent perpendiculairement au ruban. Le ruban ne supporte donc plus, après les deux butées, que des puces qui adhèrent par une face principale, sur un seul côté du ruban. Il pénètre alors dans un tunnel horizontal, de largeur et de hauteur appropriées, qui oriente les puces, au cas où elles seraient de biais. Au bout du tunnel, une butée et une fenêtre supérieure permettent d'arrêter les puces et de les prélever au moyen de la pipette aspirante d'un système de conditionnement automatique.

De façon plus précise, l'invention concerne un appareil de manipulation de puces semiconductrices de petites dimensions, destiné à prélever des puces en vrac dans une trémie d'alimentation et à les présenter une à une, orientées et dans une position fixe devant un moyen de prélèvement, ledit appareil étant caractérisé en ce que les puces sont transportées du point d'alimentation au point de prélèvement au moyen d'un ruban porteur en matière plastique, animé d'un mouvement lent de défilement, sur lequel elles adhérent par électricité statique.

L'invention sera mieux comprise par la description plus détaillée qui suit de l'appareil et du procédé de manipulation de puces de semiconducteurs, en s'aidant des figures jointes en annexes qui représentent :

- figure 1 : schéma du dispositif de prélevement des puces dans une trémie, selon l'invention,

- figure 2 : schéma du dispositif d'orientation et de stockage des puces orientées dans un tunnel, selon l'invention,

- figure 3 : schéma du tunnel, en coupe longitudinale selon l'invention,

- figure 4 : schéma implifié de l'appareil de manipulation de puces, selon l'invention.

Pour pouvoir présenter des puces de dispositifs semiconducteurs de façon unitaire et dans une position bien précise, à partir d'un volume dans lequel un grand nombre de puces sont stockées en vrac, il est nécessaire de :

- les prélever d'abord en les disposant à plat sur un support, ce qui suppose d'éliminer celles qui se présenteraient en reposant par leur tranche sur le support,

- de les orienter, toutes dans le même sens, le long d'un axe de ce support, c'est-à-dire de redresser celles qui se présenteraient à plat sur le support, mais de biais par rapport à un axe de référence.

- de les stocker en un lieu où un dispositif de prélèvement tel qu'une pipette aspirante peut les prélever, une à une, pour déposer ensuite la puce prélevée sur une embase sur laquelle est ensuite fixée.

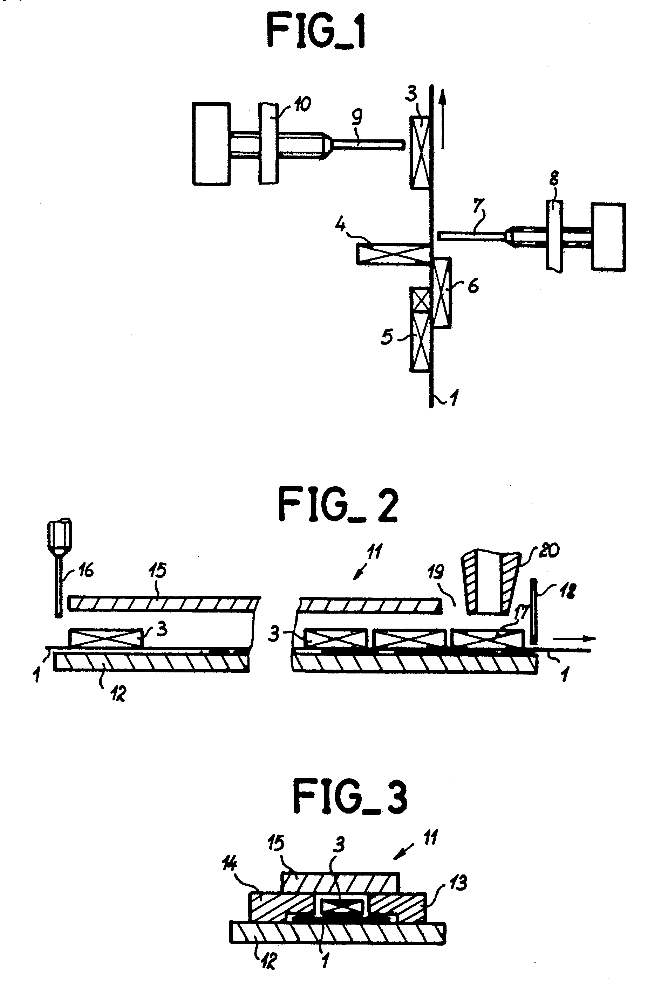

La figure 1 représente un schéma du dispositif de prélèvement de puces selon l'invention. Le fondement de ce dispositif repose sur le phénomène bien connu de l'électricité statique développée et stockée dans les matériaux isolants tels que les matières plastiques. Le support qui sert de vecteur de déplacement aux puces est un ruban de matière plastique 1, dont une boucle sans fin tourne dans l'appareil selon l'invention. Parmi de nombreuses possibilités, les films de polyesters, tels que ceux qui servent dans les rubans pour enregistrement magnétique, présentent la souplesse et les propriétés d'électricité statique qui conviennent parfaitement.

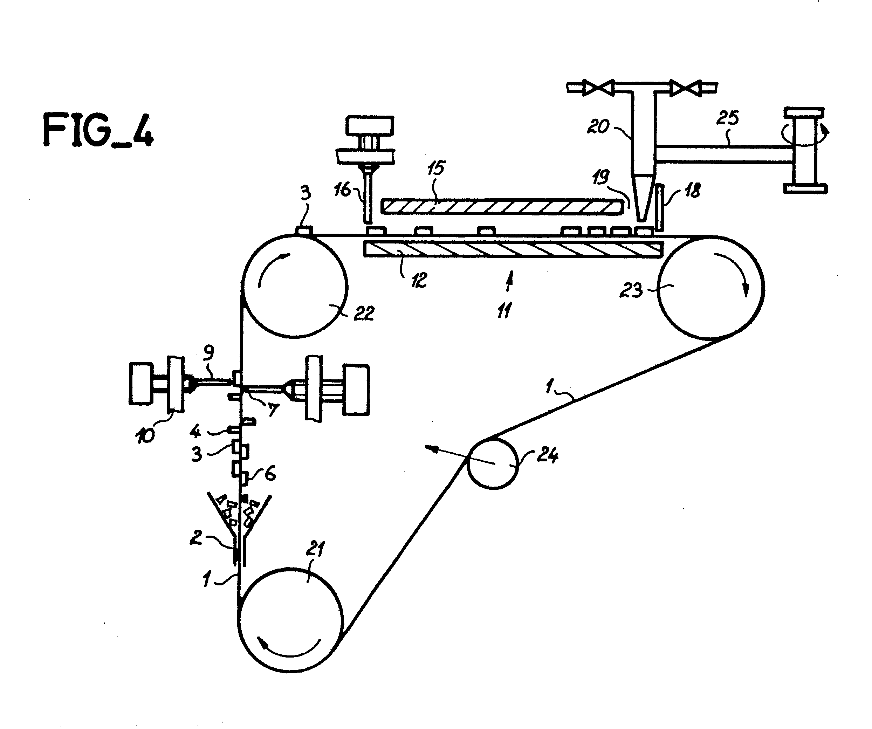

Ce ruban 1 traverse une trémie 2 en forme d'entonnoir qui n'est pas représentée sur la figure 1, mais qui apparait sur la figure 4. Dans cette trémie sont versées les puces semiconductrices, en vrac. Le ruban 1 est disposé, dans cette région de l'appareil, sensiblement selon une verticale, et il est animé d'un mouvement lent du bas vers le haut - selon la verticale du lieu bien entendu. Il est chargé d'électricité statique en partie par frottement sur la trémie 2, en partie par frottement sur les puces semiconductrices : il entraine donc dans son déplacement des puces qui adhèrent sur les deux faces principales du ruban par attraction statique.

Quatre puces 3 à 6 sont représentées sur la figure 1. La première opération consiste à ne conserver de puces que sur une seule première face principale du ruban 1, celle qui deviendra par la suite - voir figures 2 et 4 - la face supérieure du ruban, lorsqu'il se déplace à l'horizontale. Pour cela, toutes les puces telles que celle représentée en 6, qui adhèrent sur la seconde face principale qui deviendra la face inférieure du ruban, sont arrêtées par une première butée réglable 7 qui frotte sur le ruban 1, ou en est espacée d'une distance inférieure à l'épaisseur d'une puce. Les puces, arrêtées par la butée 7, retombent dans la trémie 2. Il est commode que la butée 7 soit réglable en position : elle est avantageusement portée par une tige filetée qui se déplace, par rotation d'un bouton moleté, dans un support fixe 8.

Sur la face dite "supérieure" du ruban 1, les puces semiconduc-trices peuvent se présenter dans diverses positions. Elles sont triées par une seconde butée 9, du même type que la première butée 7, et réglable par rapport au ruban 1 et à un support fixe 10. La distance qui sépare la butée 9 de la face supérieure du ruban 1 est réglée pour laisser passer, dans le défilement du ruban, les puces telles que 3 et 5 qui adhèrent à plat sur le ruban, c'est-à-dire par l'une de leurs faces principales. Au contraire, une puce telle que 4, qui adhère par sa tranche sur le ruban, est arrêtée par la butée 9 : selon les cas et l'attraction statique, soit elle retombe dans la trémie 2, soit la butée 9 la fait basculer à plat sur le ruban 1.

A l'issue de cette première zone de l'appareil de manipulation de puces selon l'invention, on a donc des puces qui se présentent :
- sur une seule face d'un ruban support,
- en ordre linéaire, le long du ruban,
- à plat sur le ruban.

Toutefois, tandis que certaines puces telles que 3 sont orientées avec deux faces latérales parallèles à l'axe de défilement du ruban porteur 1, d'autres telles que 5 se présentent de biais, ou de travers : aucune de leurs faces latérales n'est parallèle à l'axe de défilement du ruban 1. Les puces de ce second cas, qui représentent la majorité, sont donc orientées et stockées dans une seconde zone de l'appareil, qui est représentée en figure 2.

Cette seconde zone est constituée par un tunnel 11 relativement long - de l'ordre de 5 à 10 cm - dont la partie d'entrée, vue dans le sens du défilement du ruban support des puces, permet d'orienter les puces, selon l'axe de défilement, la partie centrale permet de les stocker et la partie de sortie permet de les prélever, une à une.

La lecture de la figure 2, sur laquelle sont représentées les deux extrémités due tunnel 11, est facilitée et complétée par la figure 3 qui représente une coupe transversale du tunnel.

Tandis que la première zone de prélèvement de l'appareil est sensiblement verticale, la deuxième zone du tunnel est horizontale.

Le tunnel 11 comprend une embase 12, plane et lisse, sur laquelle repose le ruban 1 dont la face supérieure porte des puces. Il comprend également deux guides latéraux 13 et 14, dont les faces internes au tunnel 11 sont également linéaires et lisses, de façon à laisser glisser les puces entrainées par le ruban 1. Ces guides 13 et 14 sont solidaires de l'embase 12, mais l'un au moins, 14 par exemple, peut être réglé en position de façon que l'intervalle séparant les deux guides soit un peu supérieur aux dimensions horizontales des puces, pour éviter que celles-ci ne se bloquent dans le tunnel. Les guides latéraux 13 et 14 sont en outre chamfreinés à leur base, en fonction de la largeur du ruban 1 : un ruban de 3 ou 5 mm de largeur par exemple véhicule des puces qui peuvent avoir 0,25 à 0,54 mm de côté. La largeur du tunnel est donc légèrement supérieure à 0,25 ou 0,54 mm, mais les guides latéraux sont chamfreinés pour ne pas bloquer le ruban, mais au contraire le guider.

Le tunnel 11 est recouvert par une plaque 15, généralement amovible et transparente pour pouvoir surveiller le stockage des puces alignées dans la partie centrale. Ce couvercle est avantageusement une plaque de verre ou de matériau transparent ou semi-transparent. Il suffit qu'il soit distant de environ 1 mm de l'embase 12 pour que les puces circulent dans le tunnel 11 sans accrocher au couvercle 15.

La partie d'entrée du tunnel 11 comporte une troisième butée réglable 16, identique aux butées 7 et 9. Elle a pour fonction de faire basculer les puces qui, après le passage de la seconde butée 9, auraient pris une position "dressée" sur la tranche, telle que la puce 4, pour une raison quelconque.

A l'entrée du tunnel, les guides latéraux 13 et 14 sont biseautés, de façon à former un entonnoir débouchant sur la partie centrale du tunnel. Ceci a deux objectifs :
- ramener dans l'axe du ruban porteur 1 les puces qui adhèrent sur les bords de la face supérieure du ruban, et donc présenter ces puces dans l'axe du tunnel 11,
- orienter les puces qui, telle la puce 5 en figure 1, se présentent de biais par rapport à l'axe de défilement du ruban 1. La forme biseautée des guides latéraux 13 et 14 réoriente ces puces, et les présente dans le tunnel avec leurs faces latérales parallèles aux faces internes du tunnel 11.

Dans la partie centrale du tunnel, les puces 3, alignées entre les guides latéraux 13 et 14, viennent buter contre la première puce 17, en position d'attente dans la partie de sortie du tunnel : il y a donc stockage de puces présentées en bonne position pour être prélevées, une à une.

En effet, une butée 18, en sortie de tunnel, est réglée pour s'approcher du ruban porteur 1 d'une distance inférieure à l'épaisseur d'une puce. Cette quatrième butée 18 bloque donc les puces qui, bien que plaquées sur le ruban 1 par l'électricité statique, glissent sur le ruban et restent sur place dans le tunnel.

Une ouverture 19 dans le couvercle 15 du tunnel a des dimensions au moins égales à celles d'une puce 17, et à celles d'une pipette aspirante 20 de manipulation : une puce est prélevée par la pipette, et déposée sur le substrant de boitier ou de circuit hybride sur lequel elle doit être fixée.

Avant d'être fixée définitivement sur son substrat, la puce sera identifiée électriquement pour reconnaitre si elle est dans le bon sens, par exemple pour une diode, reconnaitre le côté du substrat semiconducteur et le côté de la couche active ou de la jonction, de façon à ne pas braser la puce à l'envers. Mais ces moyens d'identifica-tion sont bien connus, et ne font pas partie du domaine de l'invention.

La figure 4 représente un schéma simplifié de l'appareil de manipulation de puces semiconductrices, selon l'invention. L'ensemble de l'appareil peut facilement être rendu solidaire d'un support vertical rigide et stable, tel qu'une plaque de duralumin qui sert de plan de référence aux différentes pièces de l'appareil.

Le ruban 1 porteur de puces est en boucle sans fin, et il enveloppe trois poulies, ou des surfaces arrondies de glissement équivalentes, 21, 22 et 23. Les axes de deux de ces poulies 21 et 22 sont sensiblement dans un même plan vertical, tandis que les axes des poulies 22 et 23 sont dans un plan horizontal, correspondant au tunnel 11. Au moins l'une de ces trois poulies, 21 par exemple, est entrainée par un moteur électrique, pour communiquer au ruban porteur 1 une vitesse de défilement qui corresponde sensiblement au débit des puces prélevées par la pipette 20. Une quatrième poulie 24, ou un tenseur, applique une tension au ruban 1.

La trémie 2, traversée par le ruban 1, est disposée entre les deux poulies 21 et 22. Alimentée en puces en vrac, la trémie 2 charge le ruban 1 de puces 3, 4, 6 qui adhèrent sur ses deux faces. Après les butées réglables 7 et 9, le ruban 1 ne porte plus que des puces à plat, sur une seule face.

Le tunnel 11 est disposé entre les poulies 22 et 23 : à sa sortie, la pipette aspirante 20 est solidaire d'un bras 25 qui est mobile autour d'un axe de rotation, pour manipuler les puces.

Les axes des poulies, les supports 8 et 10 des butées réglables, le tunnel 11 et avantageusement le support 25 de la pipette de manipulation sont tous solidairement fixés sur la plaque support vertical de l'appareil, lequel est en outre protégé contre les vibrations, de façon à permettre le repérage de la pipette par rapport à la puce à prélever.

Bien entendu, tout l'appareil est conçu pour que les charges électrostatiques développées dans le ruban porteur en matière plastique ne soient pas dérivées à la terre. Au contraire, le ruban peut être volontaire chargé au moyen d'un frotteur approprié qui engendre des charges électrostatiques.

La réalisation de l'appareil peut prendre des formes plus perfectionnées - par exemple automatisées - que celles qui ont été décrites, sans pour autant sortir du cadre de l'invention, qui est précisée par les revendications suivantes.

**Revendications**

1. Appareil de manipulation de puces semiconductrices de petites dimensions, destiné à prélever des puces (3, 4, 5, 6) en vrac dans une trémie d'alimentation (2) et à les présenter une à une, orientées et dans une position fixe (17) devant un moyen de prélèvement (20), ledit appareil étant caractérisé en ce que les puces sont transportées du point d'alimentation (2) au point de prélèvement au moyen d'un ruban porteur (1) en matière plastique, animé d'un mouvement lent de défilement, sur lequel elles adhèrent par électrique statique.

2. Appareil de manipulation de puces selon la revendication 1, caractérisé en ce qu'il comprend une première zone dans laquelle le ruban porteur (1), d'axe de défilement sensiblement vertical, traverse la trémie d'alimentation (2) et s'y charge de puces (3, 4, 5, 6) sur ses deux faces,
- les puces (3, 4, 5) d'une première face du ruban (1) étant triées par une butée réglable (9) qui ne laisse passer que les puces (3, 5) qui sont à plat sur le ruban (1) et arrête les puces (4) qui adhèrent au ruban (1) par une tranche,
- les puces (6) d'une deuxième face du ruban (1) sont toutes arrêtées par une butée réglable (7), qui les fait retomber dans la trémie d'alimentation (2)

3. Appareil de manipulation de puces selon la revendication 1, caractérisé en ce qu'il comprend une deuxième zone d'orientation dans laquelle un tunnel (11), sensiblement horizontal, est parcouru par le ruban porteur (1), chargé de puces (3) sur sa face supérieure, les dimensions internes de tunnel (11) étant telles que les puces y sont toutes orientées de la même façon par deux guides latéraux (13, 14), et y sont stockées par une butée (18) qui maintient une puce (17) devant une fenêtre (19) de prélèvement par une pipette aspirante (20).

4. Appareil de manipulation de puces selon la revendication 3, caractérisé en ce que le tunnel (11) comporte :
- une embase (12), rigide, plane et lisse, sur laquelle glisse le ruban porteur (1)
- deux guides latéraux (13, 14), laissant entre eux un espace légèrement supérieur aux dimensions latérales d'une puce (3), et dont la base est chamfreinée pour laisser glisser le ruban (1)
- un couvercle (15) en matériau transparent, dans lequel est ménagée une fenêtre (19) de dimensions au moins égales aux dimensions d'une puce (17)
- une butée réglable (16) à l'entrée du tunnel (11)

- une butée fixe (18) à la sortie du tunnel (11)

5. Appareil de manipulation de puces selon la revendication 3, caractérisé en ce que le tunnel (11) comprend trois parties :

- une partie d'orientation des puces (3) dans laquelle les guides latéraux (13, 14), biseautés, orientent les puces, leurs tranches latérales étant parallèles aux guides latéraux

- une partie de stockage, dans laquelle les puces, bloquées par la butée fixe (18), sont en attente de prélèvement,

- une partie de prélèvement dans laquelle une puce (17) est prélevée, à travers la fenêtre (19) par une pipette aspirante (20

6. Appareil de manipulation de puces selon la revendication 1, caractérisé en ce que le ruban (1) porteur de puces est une boucle sans fin, tendue entre trois poulies (21, 22, 23) dont l'une (21) au moins est motrice du ruban (1) et dont :

-deux (21, 22) ont des axes situés dans un même plan sensiblement vertical, et définissent la première zone d'alimentation en puces (3, 4, 5, 6) du ruban,

- deux (22, 23) ont des axes situés dans un même plan horizontal, et définissent la deuxième zone d'orientation et stockage des puces dans le tunnel (11).

7. Appareil de manipulation de puces selon l'une quelconque des revendications 1 à 6, caractérisé en ce que les pièces qui le constituent, poulies (21, 22, 23), butées réglables (7, 9, 16), trémie d'alimentation (2), tunnel (11), sont solidaires d'un bati vertical rigide.

0265330

# FIG_1

# FIG_2

# FIG_3

FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A- 957 494  (CONTINENTAL CAN)<br>* En entier *<br>--- | 1,2 | B 65 G  47/14<br>B 65 G  15/58<br>H 01 L  21/00 |
| A | DE-C- 813 016  (PHILIPS)<br>* En entier *<br>----- | 1 | |

**DOMAINES TECHNIQUES RECHERCHES (Int. Cl.4)**

B 65 G
H 01 L

Le présent rapport a été établi pour toutes les revendications

| Lieu de la recherche | Date d'achèvement de la recherche | Examinateur |
|---|---|---|
| LA HAYE | 11-01-1988 | OSTYN T.J.M. |